# FASCICULE DE BREVET EUROPEEN

(11) **EP 1 524 560 B1**
(45) Date de publication et mention de la délivrance du brevet: **24.01.2007**
(21) Numéro de dépôt: 04292428.2
(22) Date de dépôt: 13.10.2004
(51) Int. Cl.: G03F 7/20

(54) **Ensemble d'exposition à la lumière d'un panneau de circuit imprimé double face et installation comportant au moins un tel ensemble d'exposition**
Anordnung zum zweiseitigen Beleuchten einer gedruckten Schaltungsplatte und Vorrichtung mit wenigstens einer solchen Anordnung
System for illuminating two sides of a printed circuit board and apparatus with at least one such system

(30) Priorité: 17.10.2003 FR 0312149
(43) Date de publication de la demande: 20.04.2005
(73) Titulaire: AUTOMA-TECH, 27100 Val de Reuil (FR)
(72) Inventeur: Gout, Grégoire P., 76420 Bihorel (FR); Cousin, Christophe E., 27190 Orvaux (FR)
(74) Mandataire: Dronne, Guy

(56) Documents cités:
- FR-A- 2 748 887

## Description

L'invention concerne un ensemble d'exposition et une installation d'exposition à la lumière comportant au moins un ensemble d'exposition d'un panneau de circuit imprimé double face à travers un premier et un deuxième cliché, lesdits premier et deuxième clichés étant chacun munis d'une marque de repérage, comportant :
- un bâti fixe dans un plan sensiblement horizontal,
- un premier et un deuxième support de cliché respectivement destinés à supporter le premier et le deuxième cliché,
- des moyens de rapprochement/écartement permettant de rapprocher et écarter les premier et deuxième supports de cliché l'un par rapport à l'autre, et
- des moyens de maintien pour maintenir fixe dans son plan le panneau de circuit imprimé par rapport au bâti, le panneau de circuit imprimé étant maintenu entre lesdits premier et deuxième supports de cliché, ledit panneau de circuit imprimé étant muni d'un marquage de repérage en position.

De telles installations permettent la réalisation de cartes de circuits imprimés en faisant intervenir une étape d'insolation pour définir des pistes conductrices par photogravure.

Les installations connues ont pour fonction d'exposer les panneaux de circuits imprimés mis en place dans un ensemble d'exposition pendant un temps donné à une source lumineuse, généralement une source d'ultraviolets pour insoler une partie correspondante d'encre photosensible ou de film photosensible préalablement déposé sur le circuit imprimé. Cette insolation étant faite au travers de clichés qui définissent les pistes du circuit imprimé, on comprend que la précision de positionnement du cliché par rapport au panneau de circuit imprimé a un rôle fondamental.

On connaît de telles installations et ensembles d'expositions qui permettent d'exposer à la lumière une plaque de circuit imprimé double face à travers des clichés, par exemple comme celui décrit dans FR 2 748 887. Cependant, le positionnement des deux clichés situés de part et d'autre du panneau de circuit imprimé est réalisé de manière indépendante à l'aide de moyens de déplacement indépendants. Le positionnement des supports de cliché par rapport au panneau de circuit imprimé pouvant être précis à plus ou moins 5 µm près, il est nécessaire d'utiliser des moyens de déplacement très précis et donc très onéreux pour chacun des deux clichés.

En outre, pour pouvoir rattraper les erreurs de positionnement du cliché par rapport au panneau de circuit imprimé, il faut permettre un déplacement en translation (X, Y) selon les deux côtés du cliché et de préférence un déplacement en rotation (e) du cliché dans son plan. Pour ce faire, il est connu d'utiliser des moyens de déplacement individuel pour chacun des deux supports de clichés.

Un but de l'invention est de permettre la réalisation de cartes de circuits imprimés double face de manière fiable, tout en étant plus économe que les installations connues qui comportent un ensemble d'exposition avec des moyens de déplacement individuels pour chacun des deux supports de cliché.

Ce but de l'invention est atteint par le fait que cet ensemble d'exposition selon l'invention comporte :
- des moyens de déplacement commun permettant de déplacer conjointement les premier et deuxième supports de cliché dans leur plan par rapport au bâti en fonction d'une information de déplacement commun, et
- des moyens de déplacement séparé permettant de déplacer le deuxième support de cliché dans son plan par rapport au premier support de cliché en fonction d'une information de déplacement séparé.

L'invention concerne également une installation d'exposition à la lumière d'un panneau de circuit imprimé double face à travers un premier et un deuxième cliché, lesdits premier et deuxième clichés étant chacun munis d'une marque de repérage, comportant :
- des moyens de détection pour détecter des erreurs de position entre ledit panneau de circuit imprimé, le premier et le deuxième support de cliché, les erreurs de positionnement détectées entre au moins le premier support de cliché et le panneau de circuit imprimé formant l'information de déplacement commun, et les erreurs de positionnement détectées entre le deuxième support de cliché et l'un parmi le premier support de cliché et le panneau de circuit imprimé formant l'information de déplacement séparé, et
- des moyens pour générer et diriger un faisceau lumineux vers chacun des premier et deuxième supports de cliché.

Cette installation se caractérise en ce qu'elle comporte au moins un ensemble d'exposition tel que précité.

Les moyens pour générer et diriger un faisceau lumineux peuvent préférentiellement comporter une unique source lumineuse et des moyens optiques pour diriger le faisceau lumineux émis par ladite source lumineuse vers chacun desdits premier et deuxième supports de cliché, ou deux sources lumineuses qui sont alors situées respectivement en regard des premier et deuxième supports de cliché.

De la puissance lumineuse arrivant sur le cliché dépend la qualité des pistes du circuit imprimé réalisé. On comprend donc, qu'en présence d'une seule source lumineuse, l'insolation se fera préférentiellement successivement vers le premier et le deuxième support de cliché, de sorte que la puissance lumineuse fournie par la source lumineuse puisse être employée en totalité pour l'insolation d'un cliché. Il peut toutefois être prévu de diviser par deux la puissance fournie par la source lumineuse pour insoler simultanément les deux clichés, pour peu que la source lumineuse offre une puissance suffisante pour être répartie sur les deux clichés et réaliser une insolation dans de bonnes conditions.

Le panneau de circuit imprimé étant fixe, une bonne exposition de ce premier est réalisée dès lors que les premier et deuxième supports de cliché sont bien positionnés par rapport au panneau. Pour ce faire, avec les moyens de déplacement selon l'invention, il suffit de procéder à un bon positionnement du premier support de cliché par rapport au panneau de circuit imprimé ou par rapport au deuxième support de cliché et à un bon positionnement du deuxième support de cliché par rapport au panneau de circuit imprimé ou par rapport au premier support de cliché.

En fait, les moyens de déplacement commun permettent en déplaçant conjointement les deux supports de cliché, de positionner le premier support de cliché, tandis que les moyens de déplacement séparé permettent de positionner le deuxième support de cliché.

L'information de déplacement commun comporte une information sur un déplacement relatif à effectuer entre au moins le premier support de cliché et le panneau de circuit imprimé ou entre les premier et deuxième supports de cliché et le panneau de circuit imprimé ; tandis que l'information de déplacement séparé comporte selon que le panneau de circuit imprimé est présent à ce stade du positionnement, une information sur un déplacement relatif à effectuer entre le deuxième support de cliché et le premier support de cliché ou entre le deuxième support de cliché et le panneau de circuit imprimé.

Ainsi, le positionnement des supports de cliché peut se faire d'une part, pour chacun d'entre eux par rapport au panneau de circuit lui-même (lorsqu'il est présent), c'est-à-dire des positionnements ayant pour seule référence le panneau de circuit imprimé. Le positionnement des clichés peut se faire d'autre part, en positionnant un support de cliché par rapport à l'autre et au moins un des deux supports de cliché par rapport au panneau de circuit imprimé, c'est-à-dire des positionnements ayant pour référence le panneau de circuit imprimé et l'un des deux supports de clichés.

L'ordre de ces deux déplacements commun et séparé dépend de la présence ou non du circuit imprimé.

En effet, selon un premier mode opératoire, lorsque le panneau de circuit imprimé est mis en place préalablement à tout réglage, il est possible d'effectuer un déplacement conjoint dans leur plan, des supports de cliché pour positionner un premier des deux supports de cliché par rapport au panneau de circuit imprimé selon une information de déplacement commun, puis un déplacement individuel dans son plan d'un deuxième des deux supports de cliché pour le positionner de manière indépendante par rapport au premier des deux supports de cliché (déjà positionné par rapport au panneau) et/ou par rapport au panneau de circuit imprimé lui-même selon une information de déplacement séparé.

Selon un deuxième mode opératoire, lorsque le panneau de circuit imprimé n'est pas mis en place avant les réglages, un déplacement individuel est réalisé pour positionner dans son plan un premier des deux supports de cliché par rapport à un deuxième des deux supports de cliché selon une information de déplacement séparé, puis un déplacement conjoint dans leur plan des deux supports de cliché est réalisé pour positionner le deuxième support de cliché par rapport au panneau de circuit imprimé selon une information de déplacement commun. Dans ce dernier cas, le déplacement étant conjoint, le premier cliché se trouve être lui aussi bien positionné par rapport au panneau de circuit imprimé.

Ainsi, selon le mode opératoire retenu, les déplacements de positionnement se font selon une information de déplacement séparé ou commun, c'est-à-dire en fonction des erreurs détectées entre les supports de cliché eux-mêmes ou entre un des supports de cliché et le panneau de circuit imprimé.

Ces erreurs peuvent être détectées à l'aide de moyens de détection directement pourvus sur chaque ensemble d'exposition et aptes à être embarqués avec ce dernier ou bien être communs aux différents ensembles d'exposition prévus dans l'installation. Dans ce dernier cas, les moyens de détection sont fixes par rapport à la source lumineuse, ils ne sont donc pas embarqués avec les ensembles d'exposition.

Avantageusement, les moyens de déplacement séparé permettent de déplacer le deuxième support de cliché dans son plan par rapport au premier support de cliché selon l'information de déplacement séparé, en l'espèce en fonction des erreurs de positionnement détectées entre le deuxième support de cliché et le premier support de cliché et les moyens de déplacement commun permettent de déplacer conjointement les premier et deuxième supports de cliché dans leur plan par rapport au bâti selon l'information de déplacement commun, en l'espèce en fonction des erreurs de positionnement détectées entre le panneau de circuit imprimé et les premier et deuxième supports de cliché.

Le positionnement du premier support de cliché étant effectué par rapport au deuxième support de circuit imprimé, il peut être conservé même lors des changements de panneaux puisque les panneaux ne servent pas de référence à ce réglage. En outre, le réglage des supports de cliché par rapport au panneau est garanti puisque ce réglage est réalisé par déplacement conjoint des deux supports de cliché par rapport au panneau.

Ainsi, le premier réglage (entre les supports de cliché) peut être réalisé une seule fois pour une série de panneaux de circuits imprimés, c'est-à-dire tant que les clichés ne sont pas remplacés.

Avantageusement, l'installation comporte deux ensembles d'exposition et des moyens de déplacement permettant de déplacer les deux ensembles d'exposition l'un par rapport à l'autre entre alternativement une position de chargement/déchargement de panneau de circuit imprimé et une position d'insolation.

Ainsi, le premier réglage précité peut être effectué sur chacun des deux ensembles qui sont utilisés alternativement dans l'installation.

Les réglages par rapport au panneau de circuit imprimé sont, quant à eux, réitérés à chaque changement de panneau de circuit, c'est-à-dire avant chaque exposition.

Les moyens de déplacement séparé comportent avantageusement des moyens moteurs solidaires du bâti dont la sortie est reliée au deuxième support de cliché.

Ainsi, les moyens moteurs coopèrent avec le deuxième support de cliché.

Les moyens de déplacement commun comportent en outre préférentiellement une plaque de liaison qui est solidaire du premier support de cliché et qui est disposée entre le deuxième support de cliché et le bâti, et des premiers moyens de solidarisation temporaire du deuxième support de cliché sur ladite plaque de liaison.

Les moyens de solidarisation permettent l'utilisation commune des moyens moteurs. En effet, les moyens moteurs des moyens de déplacement séparé peuvent être employés pour le déplacement commun des supports de cliché. Le nombre de moyens moteurs et en particulier le nombre de moteurs peuvent donc être divisés par deux, ce qui rend l'ensemble d'exposition, et *a fortiori* l'installation, plus économes, d'autant que ces moyens moteurs devant être très précis, ils sont très onéreux. Par ailleurs, la solidarisation temporaire du deuxième support de cliché sur ladite plaque de liaison permet de garantir un bon maintien du réglage en position du premier support de cliché par rapport au deuxième support de cliché.

De manière analogue, l'ensemble d'exposition comporte en outre préférentiellement des deuxièmes moyens de solidarisation temporaire de ladite plaque de liaison par rapport au bâti. Ces deuxièmes moyens de solidarisation permettent de conserver le réglage entre les deux supports de cliché et le bâti, c'est-à-dire en fait entre les deux supports de cliché et le panneau de circuit imprimé.

Les moyens de rapprochement/écartement comportent préférentiellement au moins une liaison pivot entre le premier support et la plaque de liaison permettant au premier support de cliché d'être déplacé entre une position de positionnement dans laquelle le premier support de cliché est sensiblement parallèle au deuxième support de cliché et une position écartée dans laquelle le premier support de cliché n'est pas sensiblement parallèle au deuxième support de cliché.

Ainsi, le premier support de cliché peut être écarté par pivotement vers le haut, de sorte que l'espace disponible sur l'avant des supports de cliché est plus grand et facilite le chargement et le déchargement du panneau de circuit imprimé entre les deux supports de cliché.

Ces moyens de rapprochement/écartement seront judicieusement choisis pour garantir un bon maintien du réglage dans leur plan des deux support de cliché l'un par rapport à l'autre.

Avantageusement, les moyens de rapprochement/écartement comportent en outre des moyens formant soutien permettant de soutenir le premier support de cliché entre une position de positionnement dans laquelle le premier support de cliché est sensiblement parallèle au deuxième support de cliché tout en étant distant d'une première distance, et une position d'insolation dans laquelle le premier support de cliché est sensiblement parallèle au deuxième support de cliché en étant distant d'une deuxième distance, ladite deuxième distance étant sensiblement inférieure ou égale à ladite première distance.

Cet écartement des deux supports de cliché l'un par rapport à l'autre tout en restant parallèle entre eux, permet d'avoir un volume disponible entre les deux supports de cliché plus grand et permet donc la mise en place de panneaux de circuit imprimé d'épaisseurs variables (épaisseur inférieure ou égale à l'écartement maximal). En outre, cet écartement étant maximal au moment de la mise en place du panneau de circuit imprimé, l'insertion du panneau de circuit imprimé entre les deux supports de cliché est facilitée. Dans la position d'insolation, le support de cliché supérieur est ensuite abaissé jusqu'à un écartement correspondant sensiblement à l'épaisseur du panneau de circuit imprimé.

Afin de garantir un bon maintien du réglage des supports de cliché entre eux, les moyens de rapprochement/écartement comportent préférentiellement au moins un guidage en translation permettant au premier support de cliché d'être déplacé sensiblement perpendiculairement à son plan, entre la position de positionnement et la position d'insolation.

Ainsi, l'insertion du panneau de circuit imprimé ne remet pas en cause le réglage effectué entre les supports de cliché, puisque le rapprochement des supports de cliché se fait selon une direction sensiblement perpendiculaire à leur plan, alors que le réglage se fait dans leur plan.

L'invention sera bien comprise et ses avantages apparaîtront mieux à la lecture de la description détaillée qui suit, d'un mode de réalisation de l'invention représenté à titre d'exemple non limitatif.

La description se réfère aux dessins annexés sur lesquels :
- la figure 1 représente une vue schématique d'une installation comportant un ensemble de support de cliché selon l'invention,
- la figure 2A représente une vue schématique d'un ensemble de support de cliché selon l'invention,
- la figure 2B représente une vue de dessous de l'ensemble d'exposition selon l'invention,
- la figure 3 représente une coupe partielle de l'ensemble d'exposition de la figure 2B selon la ligne III-III,
- la figure 4 représente une coupe partielle de l'ensemble d'exposition de la figure 2B selon la ligne IV-IV, et
- la figure 5 représente une coupe partielle de l'ensemble d'exposition de la figure 2B selon la ligne V-V.

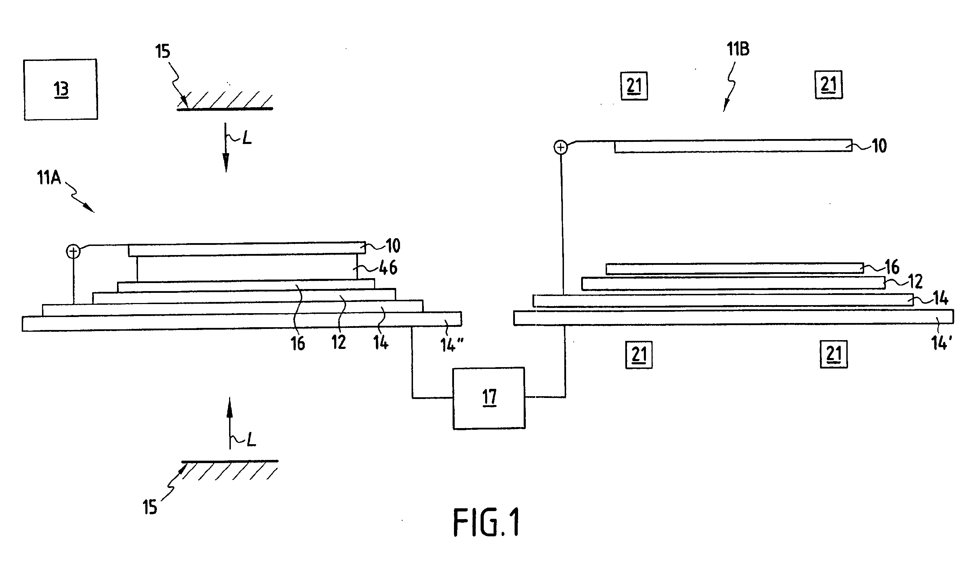

La figure 1 représente schématiquement une installation d'exposition à la lumière d'un panneau de circuit imprimé qui comporte deux ensembles d'exposition.

Un premier ensemble d'exposition 11A est mis en place en position d'insolation et un autre ensemble d'exposition 11B est en position de chargement/déchargement. L'installation pourrait bien entendu comporter d'autres ensembles d'exposition en position de chargement/déchargement.

Chacun des deux ensembles d'exposition comporte un premier support de cliché 10, un deuxième support de cliché 16 disposé sur un bâti 14 de l'ensemble d'exposition par l'intermédiaire d'une plaque de liaison 12. Un tel ensemble d'exposition est décrit plus en détails par la suite.

L'installation comporte en outre une source lumineuse 13 et des moyens optiques 15 pour diriger simultanément un faisceau lumineux L vers chacun des premier 10 et deuxième 16 supports de cliché d'un ensemble d'exposition en position d'insolation.

Pour permettre le déplacement de chacun des ensembles d'exposition entre la position d'insolation et la position de chargement/déchargement, l'installation comporte en outre des moyens de déplacement 17 de l'ensemble d'exposition. Ces moyens de déplacement 17 non détaillés de types connus, par exemple de type dispositif à rails, permettent de déplacer un ensemble d'exposition entre la position de chargement/déchargement dans laquelle le bâti 14 de l'ensemble d'exposition est préférentiellement maintenu par des moyens de maintien 14' et la position d'insolation dans laquelle le bâti 14 de l'ensemble d'exposition est préférentiellement maintenu des moyens de maintien 14" et vice-versa.

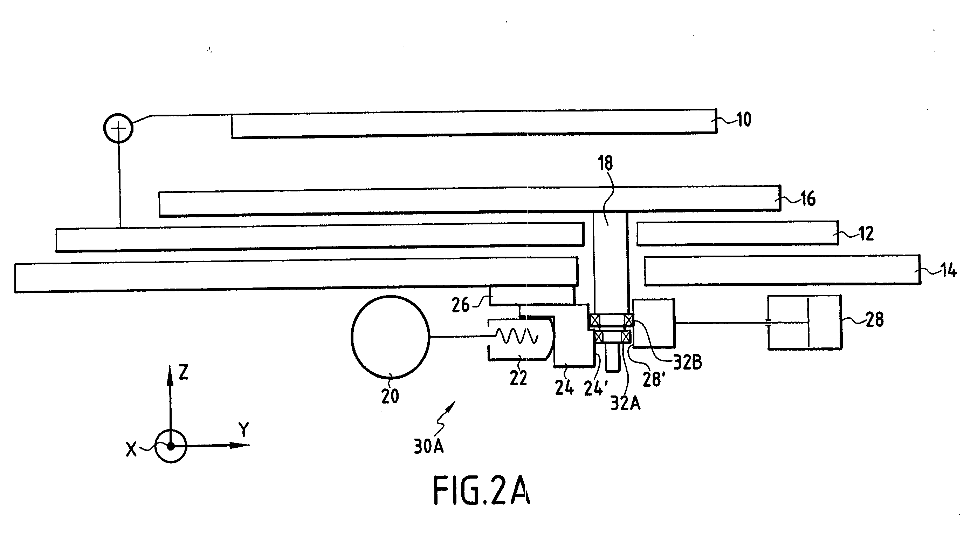

La figure 2A représente schématiquement un ensemble d'exposition selon l'invention dans lequel le premier support de cliché, en l'espèce un support de cliché supérieur 10 est solidaire de la plaque de liaison 12. Cette plaque de liaison 12 est disposée au-dessus du bâti 14 fixe dans un plan sensiblement horizontal (X, Y) par rapport à l'ensemble d'exposition et supporte le deuxième support de cliché, en l'espèce le support de cliché inférieur 16. Ainsi, le deuxième support de cliché 16 se trouve en dessous du premier support de cliché 10. Pour toute la suite, le premier support de cliché est le support de cliché supérieur 10, tandis que le deuxième support de cliché est le support de cliché inférieur 16.

De manière connue, les supports de cliché supérieur 10 et inférieur 16 comportent chacun un cadre métallique rectangulaire sur lequel est fixée une vitre sur laquelle repose un cliché supérieur, respectivement inférieur.

Pour la description qui suit, il doit être compris que les déplacements décrits concernent des déplacements de positionnement des supports, déplacements qui sont effectués au sein même d'un ensemble d'exposition et qui sont distincts de ceux précédemment décrits en relation avec un déplacement de l'ensemble entre sa position de chargement/déchargement et sa position d'insolation. Les déplacements effectués au sein de l'ensemble sont d'ailleurs préférentiellement effectués lorsque ce dernier se trouve en position de chargement/déchargement.

Pour permettre le déplacement du support de cliché inférieur 16 relatif au bâti 14, l'ensemble d'exposition comporte des moyens de déplacement séparé dont la sortie est reliée au support de cliché inférieur 16. En l'espèce, le support de cliché inférieur 16 est relié par une tige moteur 18 à des moyens moteurs qui comportent un moteur 20 et un dispositif de poussée de type vis/écrou 22. Les moyens moteurs comportent en outre un chariot 24 monté sur une glissière 26 fixée au bâti 14, qui permet de transformer à l'aide du dispositif de poussée de type vis/écrou 22, le mouvement de rotation du moteur 20 en un mouvement de translation transmis au support de cliché inférieur 16. Un vérin de contre-poussée 28 est disposé de manière diamétralement opposée au dispositif de poussée de type vis/écrou 22, par rapport à la tige moteur 18. Ce vérin de contre-poussée 28 permet d'appliquer une force de direction opposée à celle exercée par le moteur et permet ainsi de limiter les jeux, de sorte que le déplacement du support de cliché inférieur 16 est sensiblement parfaitement contrôlé.

Afin de permettre un déplacement du support de cliché dans toutes les directions (longitudinale, transversale et en rotation), les moyens moteurs comportent en fait trois ensembles tels que précédemment décrits, à savoir une tige moteur 18, un moteur 20, un dispositif de poussée de type vis/écrou 22, un chariot 24, une glissière 26 et un vérin de contre-poussée 28.

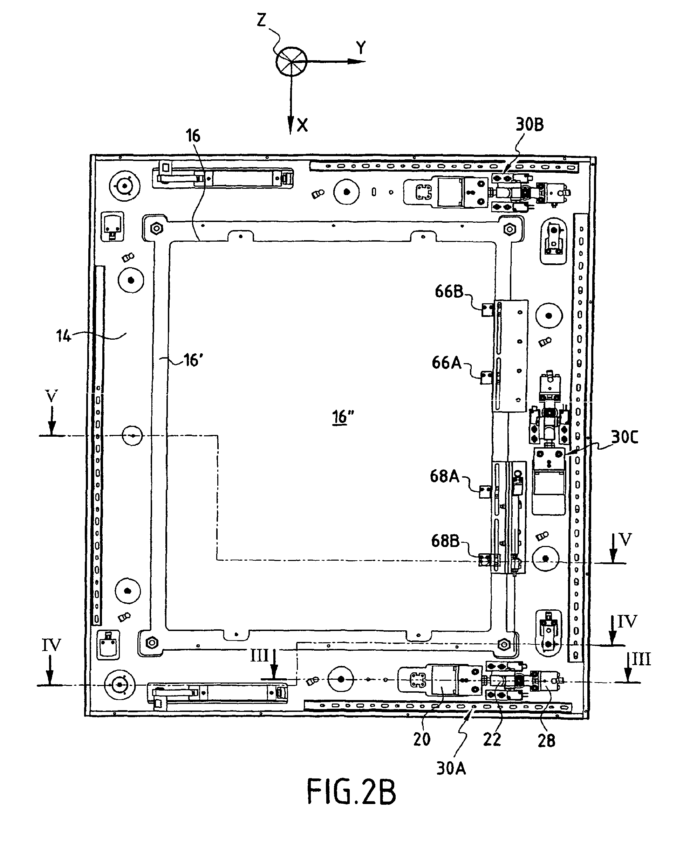

La figure 2B illustre la disposition de ces trois ensembles qui peuvent être chacun commandés séparément. Deux ensembles 30A et 30B sont disposés respectivement sur un des deux côtés de plus petite longueur, tandis que le troisième ensemble 30C est disposé sur un des deux côtés adjacents. Ces trois ensembles permettent de déplacer le support de cliché inférieur 16 dans toutes les directions ; en l'espèce, l'ensemble 30C permet un déplacement dans une première direction X ; un déplacement identique des deux ensembles 30A et 30B permet un déplacement dans une deuxième direction Y sensiblement perpendiculaire à la première direction X ; et un déplacement différent des deux ensembles 30A et 30B permet un déplacement en rotation e du support de cliché inférieur 16 autour de l'axe sensiblement vertical Z, avec pour conséquence un déplacement selon la direction Y qu'il convient de compenser par un mouvement inverse en Y. Des roulements 32A et 32B (illustrés schématiquement sur la figure 1) coopérant respectivement avec le chariot 24 et le vérin de contre-poussée 28, autorisent les déplacements en rotation du support de cliché inférieur 16 par rapport au bâti 14.

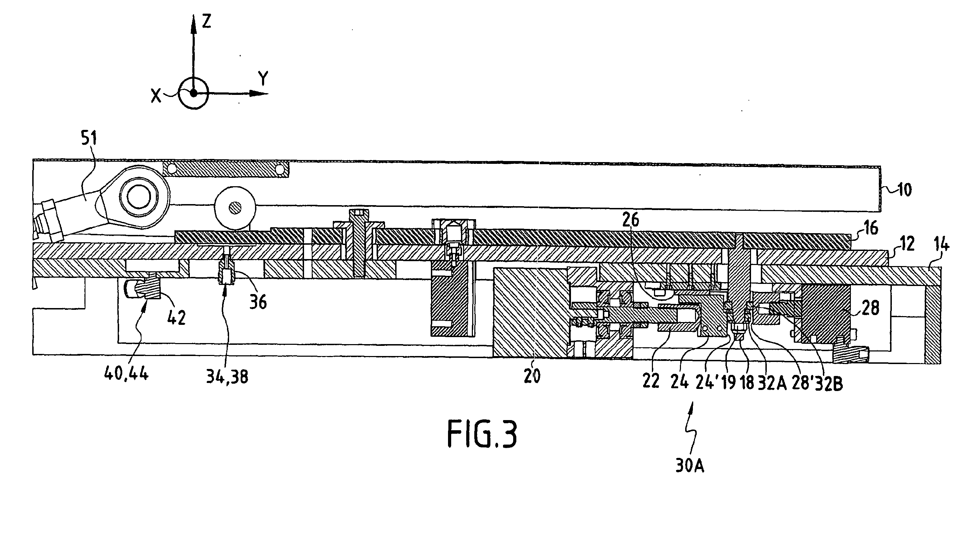

La figure 3 montre l'ensemble d'exposition de manière plus détaillée que sur la figure 2A. Les moyens de déplacement commun comportent la plaque de liaison 12 qui supporte le support de cliché inférieur 16 et des premiers moyens de solidarisation 34 coopérant avec ladite plaque de liaison 12. Ces moyens de solidarisation 34 permettent de solidariser temporairement le support de cliché inférieur 16 avec la plaque de liaison 12, c'est-à-dire avec le support de cliché supérieur 10, puisque ce dernier est lui-même solidaire de la plaque de liaison 12.

Ces moyens de solidarisation 34 comportent au moins une buse 36 reliée d'une part à la plaque de liaison 12 et d'autre part à un système d'aspiration d'air (non représenté) qui permet de faire le vide d'air entre le support de cliché inférieur 16 et la plaque de liaison 12, rendant ainsi temporairement les deux solidaires l'un de l'autre pour ne former qu'un seul élément. Dès lors que ces deux éléments sont solidaires, on comprend qu'un déplacement du support de cliché inférieur 16 à l'aide des moyens moteurs décrits précédemment permet de déplacer dans le plan (X, Y) l'ensemble constitué dudit support de cliché inférieur 16 et de la plaque 12 et permet donc un déplacement conjoint des deux supports de cliché inférieur 16 et supérieur 10.

A l'inverse, lorsque de l'air est insufflé dans la buse 36, le support de cliché inférieur 16 est maintenu sans frottement, par sustentation au-dessus de la plaque de liaison 12. Ce dispositif d'insufflation d'air dans la buse 36 forme en l'espèce des premiers moyens de sustentation sans frottement 38 du support de cliché inférieur 16 par rapport à ladite plaque de liaison 12 pour les moyens de déplacement séparé. En fait, pour maintenir le support de cliché inférieur 16 dans le plan (X, Y) au-dessus de la plaque de liaison 12, il est préférable d'avoir une répartition sensiblement homogène de l'air dans le coussin d'air. A cet effet, plusieurs buses 36, en l'espèce six buses 36 sont réparties sur la plaque de liaison 12.

Pour permettre ce déplacement vertical selon l'axe Z, du support de cliché inférieur 16 entre une position dans laquelle il est supporté par la plaque de liaison 12 et une position dans laquelle il est en légère sustentation au-dessus de cette dernière, la tige moteur 18 est montée de manière coulissante verticalement par rapport au bâti 14.

En fait, la bague intérieure respective des roulements 32A et 32B est montée serrée sur la tige moteur 18, tandis que leur bague extérieure est libre. Un écrou 19 prévu à cet effet, permet de retenir les bagues intérieures. Pour entraîner un déplacement selon l'axe Y, dans un premier sens, le chariot 24 vient en appui par une surface extérieure 24' contre la bague extérieure du roulement 32A, tandis que pour obtenir un déplacement en sens opposé selon l'axe Y, le vérin de contre-poussée 28 vient en appui par une surface extérieure 28' contre la bague extérieure du roulement 32B. Les bagues extérieures étant libres, elles sont aptes à coulisser verticalement le long de ces deux surfaces extérieures 24' et 28' qui forment alors des surfaces de guidage en translation selon l'axe Z. Pour assurer un bon guidage en translation, ces surfaces 24' et 28' sont préférentiellement rectifiées.

De la même manière, les moyens de déplacement commun comportent en outre des deuxièmes moyens de sustentation sans frottement 40 de la plaque de liaison 12 par rapport au bâti 14. Ces moyens de sustentation sans frottement 40 comportent au moins une buse 42 reliée d'une part au bâti 14 et d'autre part à un système d'insufflation d'air (non représenté) qui permet d'insuffler de l'air entre le bâti 14 et la plaque de liaison 12, de manière que le déplacement de cette dernière dans son plan (X, Y) soit facilité. Comme pour les premiers moyens de sustentation 38, ces deuxièmes moyens de sustentation 40 comportent en fait plusieurs buses 42, en l'espèce six réparties sur le bâti 14.

Ainsi, il doit être compris que lorsque les premiers moyens de solidarisation 34 ne sont pas activés, un déplacement relatif du support de cliché inférieur 16 par rapport à la plaque de liaison 12, mais aussi par rapport au support de cliché supérieur 10 et par rapport au bâti 14 est possible. A l'inverse, lorsque les premiers moyens de solidarisation temporaire 34 sont activés, le support de cliché inférieur 16 est maintenu fixe par rapport à la plaque de liaison 12, mais aussi par rapport au support de cliché supérieur 10. Par contre, son déplacement par rapport au bâti 14 dépend de l'activation des deuxièmes moyens de sustentation 40.

En effet, tant que ces deuxièmes moyens de sustentation 40 sont activés, la plaque de liaison 12 est apte à être déplacée par rapport au bâti 14. Il en va de même pour le support de cliché supérieur 10 et le support de cliché inférieur 16 relié de manière temporaire à ladite plaque de liaison 12.

Par contre, lorsque l'air présent entre la plaque de liaison 12 et le bâti 14 est aspiré à l'aide d'un système d'aspiration d'air (non représenté), par la buse 42, formant des deuxièmes moyens de solidarisation temporaire 44, la plaque de liaison 12 est maintenue fixement contre le bâti 14.

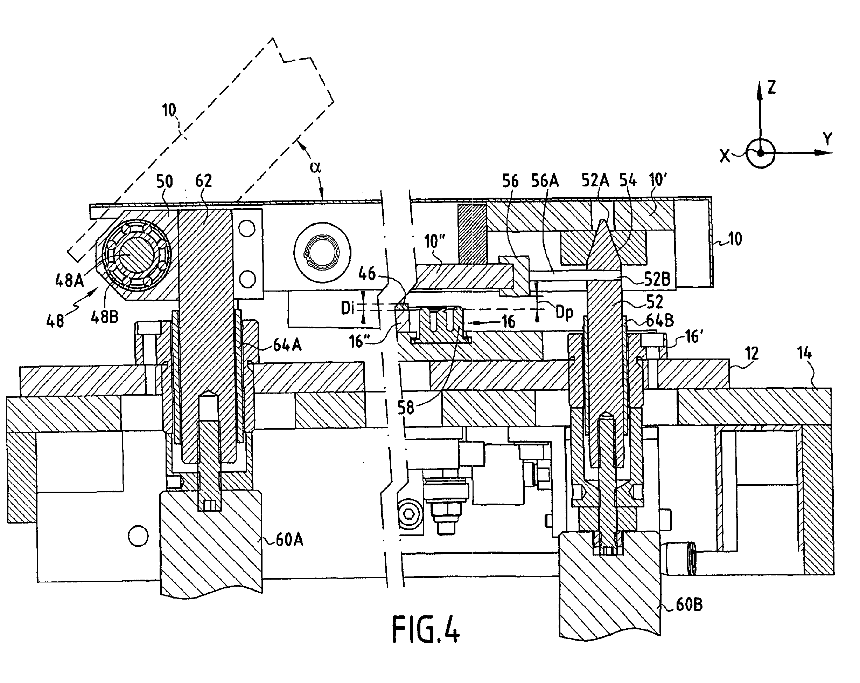

En référence à la figure 4, afin de faciliter la mise en place d'un panneau de circuit imprimé 46 entre les supports de cliché inférieur 16 et supérieur 10, en l'espèce en étant pris en sandwich entre la vitre inférieure 16" coopérant avec le cadre inférieur 16' du support de cliché inférieur 16, et la vitre supérieure 10" coopérant avec le cadre supérieur 10' du support de cliché supérieur 10, l'ensemble d'exposition comporte des moyens de rapprochement/écartement permettant de rapprocher et d'écarter le support de cliché supérieur 10 par rapport au support de cliché inférieur 16.

Ces moyens de rapprochement/écartement comportent une liaison pivot 48 comportant un axe 48A relié au support de cliché supérieur 10 et un logement 48B formé dans une plaque d'articulation 50 reliée à la plaque de liaison 12. En l'espèce, les moyens de rapprochement/écartement comportent deux liaisons pivot 48 qui sont chacune disposées respectivement sur un des deux côtés les moins longs, au voisinage d'un côté long.

Cette liaison pivot 48 permet d'écarter le support de cliché supérieur 10 par rapport au support de cliché inférieur 16 en pivotant autour de l'axe 48A. Ainsi, le support de cliché supérieur 10 est mobile entre une position de positionnement, représenté en traits forts sur la figure 4, et une position écartée, représentée en traits pointillés sur la figure 4. En position de positionnement, le support de cliché supérieur 10 est parallèle à la plaque de liaison 12, donc parallèle au support de cliché inférieur ; en fait son plan est situé dans le plan (X, Y) ; cette position est donc particulièrement adaptée aux déplacements relatifs du support de cliché supérieur 10 et du support de cliché inférieur 16. En position écartée, le support de cliché supérieur 10 n'est plus sensiblement parallèle au support de cliché inférieur 16, mais écarté angulairement de lui d'un angle α supérieur à 0°, compris entre 20° et 100°, préférentiellement de l'ordre de 40°.

Pour aider le manipulateur, les moyens de rapprochement/écartement comportent au moins un vérin d'écartement 51 apte à faciliter l'écartement du support de cliché supérieur 10 par rapport au support de cliché inférieur 16 entre une position de positionnement et une position écartée.

Les moyens de rapprochement/écartement comportent en outre des moyens de soutien qui permettent de soutenir le support de cliché supérieur 10 dans sa position de positionnement, tout en garantissant un bon maintien de sa position indépendant de tout écartement par pivotement vers le haut. Les moyens de soutien comportent des moyens formant ergot 52 coopérant avec la plaque de liaison 12, en l'espèce deux cônes de centrage qui s'étendent sensiblement perpendiculairement à cette dernière et qui présentent chacun une extrémité libre conique 52A. Chacun de ces deux cônes de centrage 52 sont disposés sur le côté opposé à celui sur lequel les liaisons pivot 48 sont disposées, respectivement en regard de ces dernières.

Chacune de ces deux extrémités libres 52A est apte à pénétrer dans un orifice 54 sensiblement conique correspondant dans le support de cliché supérieur 10.

Les moyens formant soutien comportent en outre des paires de vérins de soutien 60A et 60B, en coopération respective avec un axe de charnière 62 et le cône de centrage 52. L'axe de charnière 62 est relié de manière fixe à la plaque d'articulation 50, tandis qu'il est apte à coulisser dans la plaque de liaison 12. De même, le cône de centrage 52 est apte à coulisser dans la plaque de liaison 12. Des colonnes à billes 64A et 64B peuvent être prévues pour générer un guidage en translation par liaison glissière entre l'axe de la charnière 62 et le cône de centrage 52 respectivement.

Ces vérins de soutien 60A et 60B permettent d'adapter la distance entre les deux supports de cliché à l'épaisseur du panneau de circuit imprimé 46 qui est sensiblement comprise entre 50 µm et 6 mm.

Ainsi, lorsque les paires de vérins de soutien respectifs 60A et 60B sont activés, ils poussent respectivement l'axe de la charnière 62 et le cône de centrage 52 vers le haut ; il s'ensuit que le support de cliché supérieur 10 est poussé vers le haut selon une translation sensiblement perpendiculaire à son plan, c'est-à-dire sensiblement verticalement, vers sa position de positionnement. Tant que les paires de vérins de soutien respectifs 60A et 60B sont activés, le support de cliché supérieur 10 est maintenu dans sa position de positionnement.

Dès lors que les paires de vérins de soutien respectifs 60A et 60B sont désactivés, par le poids même du support de cliché supérieur 10 et l'activation du tirage au vide, l'axe de la charnière 62 et le cône de centrage 52 coulissent vers le bas, entraînant avec eux, le support de cliché supérieur 10 selon une translation sensiblement perpendiculaire à son plan vers une position d'insolation dans laquelle le support de cliché supérieur 10 se trouve le plus proche possible du panneau de circuit imprimé 46 disposé sur le support de cliché inférieur 16.

Dans cette position d'insolation, le support de cliché supérieur 10 se trouve à une deuxième distance Di inférieure ou égale à une première distance Dp correspondant à la position de positionnement ; le support de cliché supérieur 10 se trouve donc à une distance considérée entre la face inférieure de sa vitre 10" et la face supérieure de la vitre inférieure 16" du support de cliché inférieur 16, qui peut varier entre Dp et Di. La distance Dp à laquelle se trouve le support de cliché supérieur 10 en position de positionnement est à peine supérieure à l'épaisseur maximale habituelle d'un panneau de circuit imprimé, à savoir de l'ordre de 6 mm. Dans le cas d'une insolation d'un panneau de circuit imprimé d'épaisseur maximale, Dp et Di sont donc sensiblement égales. En fait, dans ce cas Di est à peine inférieure à Dp à cause du tirage au vide qui vient véritablement plaquer le support de cliché supérieur 10 sur le panneau de circuit imprimé.

En fait, au moment de la mise en place du circuit imprimé 46, l'opérateur actionne le déplacement du support supérieur 10 en position écartée de manière à disposer d'un maximum d'espace pour la mise en place du panneau de circuit imprimé 46, puis il insère le panneau de circuit imprimé 46 entre les deux supports de cliché pour le déposer sur des moyens de maintien décrits par la suite, puis il actionne l'abaissement du support supérieur 10 vers sa position de positionnement dans laquelle les réglages de positionnement peuvent être effectués par rapport au panneau de circuit imprimé 46. Dès lors que l'ensemble des réglages est effectué (réglages des deux supports de cliché), l'opérateur désactive les vérins de soutien 60A et 60B, et le support de cliché supérieur 10 s'abaisse par coulissement vers le bas selon l'axe vertical Z.

La liaison pivot 48, de même que les moyens formant ergot 52 et l'axe de charnière 62, seront judicieusement choisis, par exemple en étant réalisés par appairage, pour garantir un maintien des réglages de positionnement qui auront pu être effectués préalablement à la mise en place du panneau de circuit imprimé 46. Ainsi, lorsque le support de cliché supérieur 10 arrive en position de positionnement depuis une position écartée, son positionnement par rapport au support de cliché inférieur 16 est assuré.

Les moyens de rapprochement/écartement permettent de maintenir le positionnement horizontal du support de cliché supérieur 10 par rapport à la plaque de liaison 12, même après un déplacement par pivotement du support supérieur 10.

Les moyens de rapprochement/écartement comportent en outre des moyens de blocage aptes à bloquer le support de cliché supérieur 10 par rapport au support de cliché inférieur 16. En l'espèce, les moyens de blocage comportent un vérin de verrouillage 56 dont la tige 56A est apte à pénétrer dans un orifice 52B correspondant formé dans le cône de centrage 52. Ainsi, dès lors que le vérin de verrouillage 56 est activé, sa tige 56A pénètre dans l'orifice 52B du cône de centrage 52 et le support de cliché supérieur est bloqué en position de positionnement.

Ce blocage permet d'établir le vide dans l'espace entre les supports de cliché supérieur 10 et inférieur 16, qui contient le panneau de circuit imprimé 46. Ce vide permet de s'assurer de la proximité de ces trois éléments et ainsi de garantir une bonne réalisation des pistes du circuit imprimé en évitant des erreurs de parallaxe lors de l'insolation. L'aspiration au vide est réalisable, de manière connue, dans cette enceinte formée par les trois éléments précités grâce à la présence d'un joint 58 gonflable qui est disposé dans le support de cliché inférieur 16 et qui entoure le panneau de circuit imprimé 46. Sans blocage préalable en position du support de cliché supérieur 10, le gonflement du joint 58 aurait tendance à écarter le support de cliché supérieur 10 du support de cliché inférieur 16 et l'aspiration au vide serait sans effet.

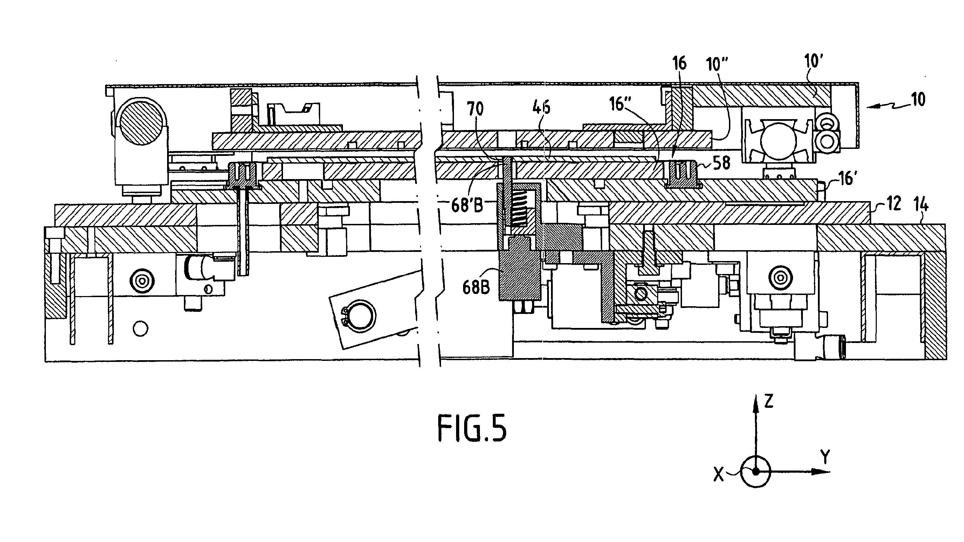

Les moyens de maintien du panneau de circuit imprimé 46 comportent des premiers et des deuxièmes moyens formant doigt de centrage qui traversent librement le support de cliché inférieur 16 (en l'espèce sa vitre 16") et la plaque de liaison 12, comme illustrés sur la figure 5. En fait, les moyens de maintien comportent deux premiers moyens formant doigt de centrage, respectivement 66A et 66B qui sont fixes par rapport au bâti 14 et deux deuxièmes moyens formant doigt de centrage, respectivement 68A et 68B. Les deuxièmes moyens formant doigt de centrage 68A et 68B sont mobiles dans le plan horizontal (X, Y) par rapport au bâti 14 selon la direction X, comme illustrés sur la figure 2A, de manière à pouvoir adapter leur écartement par rapport aux premiers moyens formant doigt de centrage 66A et 66B, en fonction de la taille du panneau de circuit imprimé à positionner. Pour assurer une étanchéité entre la vitre 16" du support de cliché inférieur et les premiers et deuxièmes moyens formant doigt de centrage 66A, 66B, 68A, 68B, qui la traversent, des moyens d'étanchéité peuvent être prévus. En effet, cette étanchéité est requise pour permettre ensuite un tirage au vide dans l'espace qui existe entre les supports de cliché supérieur 10 et inférieur 16 et qui contient le panneau de circuit imprimé 46.

Chacun des moyens formant doigt de centrage présente une extrémité libre 68'B, comme le deuxième moyen formant doigt 68B illustré sur la figure 5, qui est apte à pénétrer dans un orifice 70 correspondant de repérage ménagé dans le panneau de circuit imprimé 46. Les quatre moyens formant doigt 66A, 66B, 68A et 68B sont alignés et sensiblement parallèles à un des côtés du support de cliché inférieur 16.

Le panneau de circuit imprimé 46 est mis en place sur l'une des paires de doigts formée par un des premiers moyens formant doigt de centrage, 66A ou 66B et un des deuxièmes moyens formant doigt de centrage 68A ou 68B selon la taille du panneau de circuit imprimé et l'emplacement des orifices de repérage.

Par exemple, lorsque le panneau de circuit imprimé 46 est de grande taille, il peut être disposé sur les moyens formant doigt de centrage 66B et 68B. Les deuxièmes moyens formant doigt 68A et 68B sont mobiles en translation de manière à pouvoir rattraper les intervalles de tolérance d'usinage des trous de repérage.

On s'intéresse à présent à la description de deux modes opératoires permettant tous les deux d'insoler les deux faces d'un panneau de circuit imprimé avec une installation selon l'invention.

Selon un premier mode opératoire, le panneau de circuit imprimé 46 est mis en place par l'opérateur sur les moyens formant doigt, préalablement à tout réglage après avoir amené le support de cliché supérieur 10 en position écartée.

L'opérateur actionne l'abaissement du support de cliché supérieur 10 vers sa position de positionnement. Les premiers moyens de solidarisation temporaire 34 sont activés pour solidariser le support de cliché inférieur 16 avec la plaque de liaison 12, tandis que les deuxièmes moyens de solidarisation temporaire 44 sont désactivés ; les deuxièmes moyens de sustentation 40 sont activés pour soutenir sensiblement sans frottement la plaque de liaison 12 au-dessus du bâti 14.

Les supports de cliché supérieur 10 et inférieur 16 sont alors déplacés conjointement dans leur plan, c'est-à-dire sensiblement horizontalement dans le plan (X, Y), à l'aide des moyens moteurs 30A, 30B et 30C, de manière à positionner le support de cliché supérieur 10 par rapport au panneau de circuit imprimé 46, c'est-à-dire en fonction des erreurs détectées entre le support de cliché supérieur 10, plus précisément entre le cliché supérieur muni d'une marque de repérage et le panneau de circuit imprimé 46 muni d'un marquage de repérage en position.

Des moyens de détection, en l'espèce des moyens de détection optiques 21 du type de ceux décrits dans le document EP 618 505 permettent de détecter les erreurs de positionnement entre les différents éléments que sont les supports de cliché, plus précisément entre les clichés, et le panneau de circuit imprimé. Pour cette partie de l'installation, il est donc fait référence à la description de ce document qui doit être considérée comme partie intégrante de la présente demande.

Ces moyens de détection peuvent être uniques pour une installation, c'est-à-dire communs aux différents ensembles d'exposition ou au contraire, être propres à chacun des ensembles d'exposition. Dans ce dernier cas, il peut être prévu des moyens de détection embarqués avec l'ensemble d'exposition qui suivent alors ce dernier lors de son transfert entre la position de chargement/déchargement et la position d'insolation.

Les erreurs détectées forment les informations de déplacements commun et séparé qui vont permettre d'indiquer aux moyens moteurs 30A, 30B et 30C les instructions de déplacement selon les axes X et/ou Y des différents éléments constitués par le support de cliché supérieur 10 (par l'intermédiaire de la plaque de liaison 12) et le support de cliché inférieur 16.

Dès que le positionnement du support de cliché supérieur 10 est terminé, les deuxièmes moyens de solidarisation temporaire 44 sont activés pour bloquer la plaque de liaison 12 et donc le support de cliché supérieur 10 par rapport au bâti 14 et les premiers moyens de solidarisation temporaire 34 sont désactivés, libérant ainsi le support de cliché inférieur 16. Les premiers moyens de sustentation 38 sont quant à eux activés pour faciliter le déplacement de ce dernier support 16.

Le support de cliché inférieur 16 est alors déplacé dans le plan (X, Y) de manière individuelle par rapport au support de cliché supérieur 10 et donc aussi par rapport au panneau de circuit imprimé 46. Les réglages de positionnement de ce support de cliché inférieur 16 peuvent se faire de manière indifférente par rapport au panneau de circuit imprimé 46 ou par rapport au support de cliché supérieur 10, puisque ce dernier est déjà positionné par rapport au panneau de circuit imprimé 46.

Les premiers moyens de solidarisation temporaire 34 sont alors activés pour bloquer le support de cliché inférieur 16 sur la plaque de liaison 12 par rapport au bâti 14 et ainsi la rendre solidaire de ce dernier. Le support de cliché supérieur 10 étant solidaire de la plaque de liaison 12, les deux supports de cliché et le panneau de circuit imprimé 46 sont bien positionnés l'un par rapport à l'autre. Le support de cliché supérieur 10 est alors descendu vers sa position d'insolation, le vide est effectué et les supports de cliché supérieur 10 et inférieur 16 sont soumis simultanément à l'aide de moyens optiques connus à un faisceau optique émis par une source lumineuse (non représentée).

En fin d'exposition, l'opérateur retire le panneau de circuit imprimé qui a été insolé en amenant préalablement le support de cliché supérieur 10 en position écartée et réitère l'ensemble des opérations précitées en vue de l'insolation d'un autre panneau de circuit imprimé.

Le déplacement conjoint pour un positionnement relatif des deux supports de cliché par rapport au panneau de circuit imprimé, ainsi que le déplacement séparé pour un positionnement relatif des supports de cliché l'un par rapport à l'autre sont donc réalisés avant chaque insolation. L'installation peut être judicieusement organisée pour que l'opérateur puisse mettre en place un panneau de circuit imprimé à insoler en temps masqué, c'est-à-dire pendant qu'un autre panneau de circuit imprimé est en cours d'insolation. Dans ce cas, l'installateur se trouve au voisinage d'un ensemble d'exposition 11B en position de chargement/déchargement comme illustré sur la figure 1, afin de procéder au déchargement d'un panneau de circuit imprimé insolé et au chargement d'un panneau de circuit imprimé à insoler, tandis qu'un autre ensemble d'exposition 11A est en cours d'insolation. Dès la fin de l'exposition de ce dernier ensemble d'exposition 11A et des réglages de positionnement de l'ensemble d'exposition 11B, il actionne les moyens de déplacement 17 pour inverser la position de chacun des ensembles d'exposition 11A et 11B et ainsi de suite.

Selon un deuxième mode opératoire, avant même que le panneau de circuit imprimé 46 ne soit mis en place, un déplacement individuel est réalisé pour positionner dans son plan, correspondant au plan horizontal (X, Y), le support de cliché inférieur 16. Pour ce faire, les premiers moyens de sustentation 38 sont activés pour faciliter le déplacement du support de cliché inférieur 16, tandis que les premiers moyens de solidarisation temporaire 34 sont désactivés. Les moyens moteurs 30A, 30B et 30C permettent de déplacer séparément le support de cliché inférieur 16 par rapport au support de cliché supérieur 10 en fonction des erreurs détectées entre le support de cliché inférieur 16 et le support de cliché supérieur 10, plus précisément entre les clichés supérieur et inférieur, à l'aide des moyens de détection optiques précités. Les deuxièmes moyens de solidarisation 44 sont préférentiellement activés au moment du positionnement du support de cliché inférieur 16 par rapport au support de cliché supérieur 10, de sorte que le support de cliché supérieur 10 soit maintenu fixe, en l'espèce fixe par rapport au bâti 14.

Les premiers moyens de solidarisation 34 sont alors activés pour bloquer le support de cliché inférieur 16 sur la plaque de liaison 12 et ainsi le rendre solidaire du support de cliché supérieur 10.

Le support de cliché supérieur 10 est alors amené en position écartée et le panneau de circuit imprimé 46 est mis en place sur les moyens formant doigt de centrage 66A et 68A ou 66B et 68B. Le support de cliché supérieur 10 est alors rabattu vers sa position de positionnement.

Les deuxièmes moyens de solidarisation 44 sont désactivés et les moyens moteurs 30A, 30B et 30C entraînent conjointement le support de cliché inférieur 16 et le support de cliché supérieur 10 de manière à positionner le support de cliché supérieur 10 par rapport au panneau de circuit imprimé 46 en fonction des erreurs détectées entre le panneau de circuit imprimé 46 et de manière indifférente le support de cliché supérieur 10 et/ou le support de cliché inférieur 16 (plus précisément le cliché supérieur et/ou le cliché inférieur), ces deux supports étant déjà positionnés l'un par rapport à l'autre.

Le déplacement étant conjoint et le support de cliché inférieur 16 étant positionné par rapport au support de cliché supérieur 10, un bon positionnement du support de cliché supérieur 10 par rapport au panneau de circuit imprimé 46 entraîne un bon positionnement du support de cliché inférieur 10 par rapport au panneau de circuit imprimé 46. En fait, le bon positionnement des deux supports de cliché supérieur 10 et inférieur 16 est assuré dès lors que leur déplacement conjoint est effectué en fonction des erreurs détectées entre d'une part, le panneau de circuit imprimé 46 et d'autre part, l'un des deux ou les deux supports de cliché supérieur 10 et inférieur 16 (l'un des deux ou les deux clichés).

Les deuxièmes moyens de solidarisation temporaire 44 sont alors activés pour bloquer la plaque de liaison 12 par rapport au bâti 14 et ainsi la rendre solidaire de ce dernier. Le support de cliché inférieur 16 étant déjà bloqué par rapport à la plaque de liaison 12, les deux supports de cliché et le panneau de circuit imprimé 46 sont bien positionnés l'un par rapport à l'autre. Le support de cliché supérieur 10 est alors amené en position d'insolation par coulissement vertical vers le bas selon l'axe Z et le vide est effectué en vue de l'insolation du panneau de circuit imprimé au travers des deux clichés.

En fin d'exposition, l'opérateur retire le panneau de circuit imprimé qui a été insolé en amenant préalablement le support de cliché supérieur 10 en position écartée et met un autre panneau de circuit imprimé à insoler en place. Il n'est pas nécessaire de réitérer le déplacement séparé avant l'exposition du panneau de circuit imprimé suivant, puisque le positionnement du support de cliché inférieur 16 par rapport au support de cliché supérieur 10 est conservé. Seul le déplacement conjoint des supports de cliché est nécessairement réitéré pour réaligner les deux supports de cliché supérieur 10 et inférieur 16 par rapport au nouveau panneau de circuit imprimé qui vient d'être mis en place.

Ce deuxième mode opératoire offre donc l'avantage de conserver le positionnement relatif des deux supports de cliché l'un par rapport à l'autre pour réaliser une série de panneaux de circuit imprimé. Ce positionnement relatif des supports de cliché est donc réalisé en début d'insolation d'une série de panneaux de circuit imprimé, tandis que le déplacement conjoint pour un positionnement relatif des deux supports de cliché par rapport au panneau de circuit imprimé est réalisé avant chaque insolation. Le déplacement séparé avec toutes les activations/désactivations des moyens de solidarisation et de sustentation précités qui lui sont liées n'étant pas à réaliser avant chaque exposition, le temps de réalisation d'un panneau de circuit imprimé s'en trouve diminué, d'autant plus si l'installation est automatisée.

Il est à noter qu'une vérification peut être effectuée, dans ce deuxième mode opératoire, après chaque chargement de nouveau panneau de circuit imprimé 46, pour s'assurer du maintien du réglage des supports de cliché inférieur 16 et supérieur 10 l'un par rapport à l'autre. Si le positionnement d'un des supports de cliché n'était plus respecté, il conviendrait de re-positionner ce dernier. Dans ce cas, le positionnement s'effectuerait selon le premier mode opératoire précité, à savoir par rapport au panneau de circuit imprimé 46, puisque ce dernier serait alors présent entre les deux supports de cliché.

## Revendications

1. Ensemble d'exposition à la lumière d'un panneau de circuit imprimé (46) double face à travers un premier (10) et un deuxième cliché (16), lesdits premier et deuxième clichés (10, 16) étant chacun muni d'une marque de repérage, comportant :
- un bâti (14) fixe dans un plan (X, Y) sensiblement horizontal,
- un premier (10) et un deuxième support de cliché (16) respectivement destiné à supporter le premier et le deuxième cliché,
- des moyens de rapprochement/écartement (48, 48A, 48B, 51, 52, 52A, 52B, 56, 56A, 54, 60A, 60B, 62, 64A, 64B) permettant de rapprocher et écarter les premier et deuxième supports de cliché (10, 16) l'un par rapport à l'autre, et
- des moyens de maintien (66A, 66B, 68A, 68B) pour maintenir fixe dans son plan le panneau de circuit imprimé (46) par rapport au bâti (14), le panneau de circuit imprimé (46) étant maintenu entre lesdits premier et deuxième supports de cliché (10, 16), ledit panneau de circuit imprimé (46) étant muni d'un marquage de repérage en position,
cet ensemble **se caractérisant en ce qu'**il comporte en outre :
- des moyens de déplacement commun (12, 18, 20, 22, 24, 26, 28, 30A, 30B, 30C, 32A, 32B, 34, 36, 40, 42) permettant de déplacer conjointement les premier et deuxième supports de cliché (10, 16) dans leur plan (x, Y) par rapport au bâti (14) en fonction d'une information de déplacement commun, et
- des moyens de déplacement séparé (18, 20, 22, 24, 26, 28, 30A, 30B, 30C, 32A, 32B, 36, 38, 42, 44) permettant de déplacer le deuxième support de cliché (16) dans son plan (X, Y) par rapport au premier support de cliché (10) en fonction d'une information de déplacement séparé.

2. Ensemble d'exposition selon la revendication précédente, **caractérisé en ce que** les moyens de déplacement commun (12, 18, 20, 22, 24, 26, 28, 30A, 30B, 30C, 32A, 32B, 34, 36, 40, 42) permettent de déplacer conjointement les premier et deuxième supports de cliché (10, 16) dans leur plan (X, Y) par rapport au bâti (14) en fonction d'une information de déplacement commun fonction d'une erreur de positionnement détectée entre le panneau de circuit imprimé (46) et un des premier et deuxième supports de cliché (10, 16).

3. Ensemble d'exposition selon la revendication 1 ou 2, **caractérisé en ce que** les moyens de déplacement séparé (18, 20, 22, 24, 26, 28, 30A, 30B, 30C, 32A, 32B, 36, 38, 42, 44) permettent de déplacer le deuxième support de cliché (16) dans son plan (X, Y) par rapport au premier support de cliché (10) en fonction d'une information de déplacement séparé fonction d'une erreur de positionnement détectée entre les premier et deuxième supports de cliché (10, 16) et/ou entre le deuxième support de cliché (16) et le panneau de circuit imprimé (46).

4. Ensemble d'exposition selon l'une quelconque des revendications précédentes, **caractérisé en ce que** les moyens de déplacement séparé (18, 20, 22, 24, 26, 28, 30A, 30B, 30C, 32A, 32B, 36, 38, 42, 44) comportent des moyens moteurs solidaires (18, 20, 22, 24, 26, 28, 30A, 30B, 30C, 32A, 32B) du bâti (14) dont la sortie (18) est reliée au deuxième support de cliché (16).

5. Ensemble d'exposition selon la revendication précédente, **caractérisé en ce que** les moyens de déplacement commun (12, 18, 20, 22, 24, 26, 28, 30A, 30B, 30C, 32A, 32B, 34, 36, 40, 42) comportent en outre une plaque de liaison (12) qui est solidaire du premier support de cliché (10) et qui est disposée entre le deuxième support de cliché (16) et le bâti (14), et des premiers moyens de solidarisation temporaire (34, 36) du deuxième support de cliché (16) sur ladite plaque de liaison (12).

6. Ensemble d'exposition selon la revendication précédente, **caractérisé en ce qu'**elle comporte en outre des deuxièmes moyens de solidarisation temporaire (44, 42) de ladite plaque de liaison (12) par rapport au bâti (14).

7. Ensemble d'exposition selon la revendication 5 ou 6, **caractérisé en ce que** le deuxième support de cliché (16) se trouve en dessous du premier support de cliché (10), **en ce que** les moyens de déplacement séparé (18, 20, 22, 24, 26, 28, 30A, 30B, 30C, 32A, 32B, 36, 38, 42, 44) comportent en outre des premiers moyens de sustentation (36, 38) sans frottement du deuxième support de cliché (16) par rapport à ladite plaque de liaison (12) et **en ce que** les moyens de déplacement commun (12, 18, 20, 22, 24, 26, 28, 30A, 30B, 30C, 32A, 32B, 34, 36, 40, 42) comportent en outre des deuxièmes moyens de sustentation (40, 42) sans frottement de ladite plaque de liaison (12) par rapport au bâti (14).

8. Ensemble d'exposition selon la revendication 5 et l'une quelconque des revendications précédentes, **caractérisé en ce que** les moyens de rapprochement/écartement (48, 48A, 48B, 51, 52, 52A, 52B, 56, 56A, 54, 60A, 60B, 62, 64A, 64B) comportent au moins une liaison pivot (48, 48A, 48B) entre le premier support de cliché (10) et la plaque de liaison (12) permettant au premier support de cliché (10) d'être déplacé entre une position de positionnement dans laquelle le premier support de cliché (10) est sensiblement parallèle au deuxième support de cliché (16) et une position écartée dans laquelle le premier support de cliché (10) n'est pas sensiblement parallèle au deuxième support de cliché (16).

9. Ensemble d'exposition selon l'une quelconque des revendications précédentes, **caractérisé en ce que** les moyens de rapprochement/écartement (48, 48A, 48B, 51, 52, 52A, 52B, 56, 56A, 54, 60A, 60B, 62, 64A, 64B) comportent en outre des moyens formant soutien (52, 52A, 54, 62, 60A, 60B) permettant de soutenir le premier support de cliché (10) entre une position de positionnement dans laquelle le premier support de cliché (10) est sensiblement parallèle au deuxième support de cliché (16) tout en étant distant d'une première distance (Dp), et une position d'insolation dans laquelle le premier support de cliché (10) est sensiblement parallèle au deuxième support de cliché (16) en étant distant d'une deuxième distance (Di), ladite deuxième distance (Di) étant sensiblement inférieure ou égale à ladite première distance (Dp).

10. Ensemble d'exposition selon la revendication précédente, **caractérisé en ce que** les moyens de rapprochement/écartement (48, 48A, 48B, 51, 52, 52A, 52B, 56, 56A, 54, 60A, 60B, 62, 64A, 64B) comportent au moins un guidage en translation (64A, 64B) permettant au premier support de cliché (10) d'être déplacé sensiblement perpendiculairement à son plan (X, Y), entre la position de positionnement et la position d'insolation.

11. Ensemble d'exposition selon l'une quelconque des revendications 9 à 10, **caractérisé en ce que** les moyens de soutien (52, 52A, 54, 62, 60A, 60B) comportent en outre des moyens formant ergot (52, 52A) présentant chacun une extrémité libre (52A) apte à pénétrer dans un orifice (54) correspondant dans le premier support de cliché (10) lorsque le premier support de cliché (10) arrive en position de positionnement depuis une position écartée dans laquelle le premier support de cliché (10) n'est pas sensiblement parallèle au deuxième support de cliché (16).

12. Ensemble d'exposition selon la revendication précédente, **caractérisé en ce que** les moyens de rapprochement/écartement (48, 48A, 48B, 51, 52, 52A, 52B, 56, 56A, 54, 60A, 60B, 62, 64A, 64B) comportent des moyens de blocage (52B, 56, 56A) aptes à bloquer le premier support de cliché (10) par rapport au deuxième support de cliché (16).

13. Ensemble d'exposition selon la revendication 5 et l'une quelconque des revendications précédentes, **caractérisé en ce que** les moyens de maintien (66A, 66B, 68A, 68B) comportent des premiers (66A, 66B) et des deuxièmes moyens formant doigt de centrage (68A, 68B) qui traversent librement le deuxième support de cliché (16) et la plaque de liaison (12) et qui présentent chacun une extrémité libre (68'B) apte à pénétrer dans un orifice (70) correspondant de repérage ménagé dans le panneau de circuit imprimé (46).

14. Installation d'exposition à la lumière d'un panneau de circuit imprimé (46) double face à travers un premier (10) et un deuxième cliché (16), lesdits premier et deuxième clichés (10, 16) étant chacun muni d'une marque de repérage, comportant :
- des moyens de détection (21) pour détecter des erreurs de position entre ledit panneau de circuit imprimé (46), le premier (10) et le deuxième (16) support de cliché, les erreurs de positionnement détectées entre au moins le premier support de cliché (10) et le panneau de circuit imprimé (46) formant l'information de déplacement commun, et les erreurs de positionnement détectées entre le deuxième support de cliché (16) et l'un parmi le premier support de cliché (10) et le panneau de circuit imprimé (46) formant l'information de déplacement séparé, et
- des moyens (13, 15) pour générer et diriger un faisceau lumineux (L) vers chacun des premier et deuxième supports de cliché (10, 16),
cette installation **se caractérisant en ce qu'**elle comporte au moins un ensemble d'exposition (11A, 11B) selon l'une quelconque des revendications précédentes.

15. Installation selon la revendication précédente, **caractérisée en ce que** lesdits moyens de détection sont embarqués sur l'ensemble d'exposition.

16. Installation selon la revendication 14 ou 15, **caractérisée en ce qu'**elle comporte deux ensembles d'exposition (11A, 11B) et des moyens de déplacement (17) permettant de déplacer les deux ensembles d'exposition (11A, 11B) l'un par rapport à l'autre entre alternativement une position de chargement/déchargement de panneau de circuit imprimé et une position d'insolation.

17. Installation selon l'une quelconque des revendications 14 à 16, **caractérisée en ce que** lesdits moyens de détection comportent des moyens de détection optiques (21).

18. Installation selon l'une quelconque des revendications 14 à 17, **caractérisée en ce que** lesdits moyens pour générer et diriger un faisceau lumineux (L) comportent une source lumineuse (13) et des moyens optiques (15) pour diriger le faisceau lumineux émis par ladite source lumineuse (13) vers chacun desdits premier et deuxième supports de lumineuse (13) vers chacun desdits premier et deuxième supports de cliché (10, 16).

19. Installation selon l'une quelconque des revendications 14 à 17, **caractérisée en ce que** lesdits moyens pour générer et diriger un faisceau lumineux (L) comportent deux sources lumineuses situées respectivement en regard des premier et deuxième supports de cliché (10, 16).

## Claims

1. An assembly for exposing a double-sided printed circuit panel (46) to light through a first (10) and a second artwork (16), said first and second artworks (10, 16) each being provided with a registration mark, comprising:
- a bed (14) fixed in a substantially horizontal plane (X, Y);
- a first (10) and a second artwork support (16) respectively intended to support the first and the second artwork,
- means for moving closer/separating (48, 48A, 48B, 51, 52, 52A, 52B, 56, 56A, 54, 60A, 60B, 62, 64A, 64B) making it possible to move the first and second artwork supports (10, 16) closer together and to separate them; and
- holding means (66A, 66B, 68A, 68B) for holding the printed circuit panel (46) fixed in its plane with respect to the bed (14), the printed circuit panel (46) being held between said first and second artwork supports (10, 16), said printed circuit panel (46) being provided with a positional registration marking,
this assembly being **characterised in that** it furthermore comprises:
- common displacement means (12, 18, 20, 22, 24, 26, 28, 30A, 30B, 30C, 32A, 32B, 34, 36, 40, 42) making it possible to jointly displace the first and second artwork supports (10, 16) in their plane (X, Y) with respect to the bed (14) as a function of a common displacement information; and
- separate displacement means (18, 20, 22, 24, 26, 28, 30A, 30B, 30C, 32A, 32B, 36, 38, 42, 44) making it possible to displace the second artwork support (16) in its plane (X, Y) with respect to the first artwork support (10) as a function of a separate displacement information.

2. The exposure assembly according to the preceding claim, **characterised in that** the common displacement means (12, 18, 20, 22, 24, 26, 28, 30A, 30B, 30C, 32A, 32B, 34, 36, 40, 42) make it possible to jointly displace the first and second artwork supports (10, 16) in their plane (X, Y) with respect to the bed (14) as a function of a common displacement information dependent on a positioning error detected between the printed circuit panel (46) and one of the first and second artwork supports (10, 16).

3. The exposure assembly according to claim 1 or 2, **characterised in that** the separate displacement means (18, 20, 22, 24, 26, 28, 30A, 30B, 30C, 32A, 32B, 36, 38, 42, 44) make it possible to displace the second artwork support (16) in its plane (X, Y) with respect to the first artwork support (10) as a function of a separate displacement information dependent on a positioning error detected between the first and second artwork supports (10, 16) and/or between the second artwork support (16) and the printed circuit panel (46).

4. The exposure assembly according to any one of the preceding claims, **characterised in that** the separate displacement means (18, 20, 22, 24, 26, 28, 30A, 30B, 30C, 32A, 32B, 36, 38, 42, 44) comprise motor means (18, 20, 22, 24, 26, 28, 30A, 30B, 30C, 32A, 32B) secured to the bed (14) whose output (18) is connected to the second artwork support (16).

5. The exposure assembly according to the preceding claim, **characterised in that** the common displacement means (12, 18, 20, 22, 24, 26, 28, 30A, 30B, 30C, 32A, 32B, 34, 36, 40, 42) furthermore comprise a link plate (12) which is secured to the first artwork support (10) and which is disposed between the second artwork support (16) and the bed (14), and first means of temporary securing (34, 36) of the second artwork support (16) on said link plate (12).

6. The exposure assembly according to the preceding claim, **characterised in that** it furthermore comprises second means of temporary securing (44, 42) of said link plate (12) with respect to the bed (14).

7. The exposure assembly according to claim 5 or 6, **characterised in that** the second artwork support (16) is located below the first artwork support (10), **in that** the separate displacement means (18, 20, 22, 24, 26, 28, 30A, 30B, 30C, 32A, 32B, 36, 38, 42, 44) furthermore comprise first means of frictionless upholding (36, 38) of the second artwork support (16) with respect to said link plate (12) and **in that** the common displacement means (12, 18, 20, 22, 24, 26, 28, 30A, 30B, 30C, 32A, 32B, 34, 36, 40, 42) furthermore comprise second means of frictionless upholding (40, 42) of said link plate (12) with respect to the bed (14).

8. The exposure assembly according to claim 5 and any one of the preceding claims, **characterised in that** the means for moving closer/separating (48, 48A, 48B, 51, 52, 52A, 52B, 56, 56A, 54, 60A, 60B, 62, 64A, 64B) comprise at least one pivot link (48, 48A, 48B) between the first artwork support (10) and the link plate (12) allowing the first artwork support (10) to be displaced between a positioning position in which the first artwork support (10) is substantially parallel to the second artwork support (16) and a separated position in which the first artwork support (10) is not substantially parallel to the second artwork support (16).

9. The exposure assembly according to any one of the preceding claims, **characterised in that** the means for moving closer/separating (48, 48A, 48B, 51, 52, 52A, 52B, 56, 56A, 54, 60A, 60B, 62, 64A, 64B) furthermore comprise retaining means (52, 52A, 54, 62, 60A, 60B) making it possible to retain the first artwork support (10) between a positioning position in which the first artwork support (10) is substantially parallel to the second artwork support (16) while being a first distance (Dp) distant, and an exposure position in which the first artwork support (10) is substantially parallel to the second artwork support (16) while being a second distance (Di) distant, said second distance (Di) being substantially less than or equal to said first distance (Dp).

10. The exposure assembly according to the preceding claim, **characterised in that** the means for moving closer/separating (48, 48A, 48B, 51, 52, 52A, 52B, 56, 56A, 54, 60A, 60B, 62, 64A, 64B) comprise at least one translational guidance (64A, 64B) allowing the first artwork support (10) to be displaced substantially perpendicularly to its plane (X, Y), between the positioning position and the exposure position.

11. The exposure assembly according to any one of claims 9 to 10, **characterised in that** the retaining means (52, 52A, 54, 62, 60A, 60B) furthermore comprise lug means (52, 52A) each exhibiting a free end (52A) able to penetrate a corresponding orifice (54) in the first artwork support (10) when the first artwork support (10) arrives in the positioning position from a separated position in which the first artwork support (10) is not substantially parallel to the second artwork support (16).

12. The exposure assembly according to the preceding claim, **characterised in that** the means for moving closer/separating (48, 48A, 48B, 51, 52, 52A, 52B, 56, 56A, 54, 60A, 60B, 62, 64A, 64B) comprise locking means (52B, 56, 56A) able to lock the first artwork support (10) with respect to the second artwork support (16).

13. The exposure assembly according to claim 5 and any one of the preceding claims, **characterised in that** the holding means (66A, 66B, 68A, 68B) comprise first (66A, 66B) and second centering finger means (68A, 68B) which pass freely through the second artwork support (16) and the link plate (12) and which each exhibit a free end (68'B) able to penetrate a corresponding registration orifice (70) made in the printed circuit panel (46).

14. An installation for exposing a double-sided printed circuit panel (46) to light through a first (10) and a second artwork (16), said first and second artworks (10, 16) each being provided with a registration mark, comprising:
- detection means (21) for detecting position errors between said printed circuit panel (46), the first (10) and the second (16) artwork support, the positioning errors detected between at least the first artwork support (10) and the printed circuit panel (46) forming the common displacement information, and the positioning errors detected between the second artwork support (16) and one out of the first artwork support (10) and the printed circuit panel (46) forming the separate displacement information; and
- means (13, 15) for generating and directing a light beam (L) toward each of the first and second artwork supports (10, 16),
this installation being **characterised in that** it comprises at least one exposure assembly (11A, 11B) according to any one of the preceding claims.

15. The installation according to the preceding claim, **characterised in that** said detection means are borne by the exposure assembly.

16. The installation according to claim 14 or 15, **characterised in that** it comprises two exposure assemblies (11A, 11B) and displacement means (17) making it possible to displace the two exposure assemblies (11A, 11B) with respect to one another between alternately a printed circuit panel loading/unloading position and an exposure position.

17. The installation according to any one of claims 14 to 16, **characterised in that** said detection means comprise optical detection means (21).

18. The installation according to any one of claims 14 to 17, **characterised in that** said means for generating and directing a light beam (L) comprise a light source (13) and optical means (15) for directing the light beam emitted by said light source (13) toward each of said first and second artwork supports (10, 16).

19. The installation according to any one of claims 14 to 17, **characterised in that** said means for generating and directing a light beam (L) comprise two light sources situated respectively opposite the first and second artwork supports (10, 16).

## Patentansprüche

1. Anordnung zum zweiseitigen Beleuchten einer gedruckten Schaltungsplatte durch ein erstes (10) und ein zweites (16) Druckbild, wobei die besagten ersten und zweiten Druckbilder (10, 16) jeweils mit einer Erkennungsmarkierung versehen sind, umfassend:
- einen feststehenden Rahmen (14) in einer Ebene (X, Y), die im wesentlichen horizontal ist,
- einen ersten (10) und einen zweiten Träger des Druckbildes (16), die entsprechend dazu dienen, das erste und zweite Druckbild zu tragen,
- Mittel zum Zusammenbringen / Voneinanderentfernen (48, 48A, 48B, 51, 52, 52A, 52B, 56, 54, 60A, 60B, 62, 64A, 64B), wobei diese es gestatten, die ersten und zweiten Träger des Druckbildes (10, 16) zusammen zu bringen und voneinander zu entfernen, und
- Haltemittel (66A, 66B, 68A, 68B), um die gedruckte Schaltungsplatte (46) auf ihrer Ebene hinsichtlich des Rahmens (14) zu halten, wobei die gedruckte Schaltungsplatte (46) zwischen den besagten ersten und zweiten Trägern des Druckbildes (10, 16) gehalten wird, wobei besagte gedruckte Schaltungsplatte (46) mit einer Erkennungsmarkierung zur Bezeichnung der Position versehen ist,
wobei diese Anordnung **dadurch gekennzeichnet ist, daß** diese außerdem umfaßt:
- Mittel zum gemeinsamen Verschieben (12, 18, 20, 22, 24, 26, 28, 30A, 30B, 30C, 32A, 32B, 34, 36, 40, 42), die das Verschieben der ersten und zweiten Träger des Druckbildes (10, 16) gemeinsam in ihrer Ebene (X, Y) hinsichtlich des Rahmens (14) entsprechend einer Information zum gemeinsamen Verschieben ermöglichen, und
- Mittel zum getrennten Verschieben (18, 20, 22, 24, 26, 28, 30A, 30B, 30C, 32A, 32B, 36, 38, 42, 44), die das Verschieben des zweiten Trägers des Druckbildes (16) in seiner Ebene (X, Y) hinsichtlich des ersten Trägers des Druckbildes (10) entsprechend einer Information zum getrennten Verschieben ermöglichen.

2. Anordnung zum Beleuchten nach dem vorangegangenen Anspruch, **dadurch gekennzeichnet, daß** die Mittel zum gemeinsamen Verschieben (12, 18, 20, 22, 24, 26, 28, 30A, 30B, 30C, 32A, 32B, 34, 36, 40, 42) das gemeinsame Verschieben der ersten und zweiten Träger des Druckbildes (10, 16) in ihrer Ebene (X, Y) hinsichtlich des Rahmens (14) im Hinblick auf eine Information zum gemeinsamen Verschieben gewährleisten, die eine Funktion eines Positionierungsfehlers ist, der zwischen der gedruckten Schaltungsplatte (46) und einem der ersten und zweiten Träger des Druckbildes (10, 16) festgestellt wurde.

3. Anordnung zum Beleuchten nach Anspruch 1 oder 2, **dadurch gekennzeichnet, daß** die Mittel zum getrennten Verschieben (18, 20, 22, 24, 26, 28, 30A, 30B, 30C, 32A, 32B, 36, 38, 42, 44) das Verschieben des zweiten Trägers des Druckbildes (16) in seiner Ebene (X, Y) im Verhältnis zum ersten Träger des Druckbildes (10) entsprechend einer Information zum getrennten Verschieben gewährleisten, die eine Funktion eines Positionierungsfehlers ist, der zwischen den ersten und zweiten Trägern des Druckbildes (10, 16) festgestellt wurde und / oder zwischen dem zweiten Träger des Druckbildes (16) und der gedruckten Schaltungsplatte (46).

4. Anordnung zum Beleuchten nach einem beliebigen der vorangegangenen Ansprüche, **dadurch gekennzeichnet, daß** die Mittel zum getrennten Verschieben (18, 20, 22, 24, 26, 28, 30A, 30B, 30C, 32A, 32B, 36, 38, 42, 44) zusammenhängende Motormittel (18, 20, 22, 24, 26, 28, 30A, 30B, 30C, 32A, 32B, 36, 38, 42, 44) des Rahmens (14) umfassen, wobei der Ausgang (18) mit dem zweiten Träger des Druckbildes (16) verbunden ist.

5. Anordnung zum Beleuchten nach dem vorangegangenen Anspruch, **dadurch gekennzeichnet, daß** die Mittel zum gemeinsamen Verschieben (12, 18, 20, 22, 24, 26, 28, 30A, 30B, 30C, 32A, 32B, 36, 38, 42) außerdem eine Verbindungsplatte (12) umfassen, die mit dem ersten Träger des Druckbildes (10) verbunden ist und die zwischen dem zweiten Träger des Druckbildes (16) und dem Rahmen (14) angeordnet ist, sowie erste Mittel zur vorübergehenden Anordnung (34, 36) des zweiten Trägers des Druckbildes (16) auf besagter Verbindungsplatte (12).

6. Anordnung zum Beleuchten nach dem vorangegangenen Anspruch, **dadurch gekennzeichnet, daß** diese außerdem zweite Mittel zur vorübergehenden Anordnung (44, 42) der besagten Verbindungsplatte (12) im Hinblick auf den Rahmen (14) umfassen.

7. Anordnung zum Beleuchten nach Anspruch 5 oder 6, **dadurch gekennzeichnet, daß** der zweite Träger des Druckbildes (16) sich unterhalb des ersten Trägers des Druckbildes (10) befindet und daß die Mittel zum getrennten Verschieben (18, 20, 22, 24, 26, 28, 30A, 30B, 30C, 32A, 32B, 36, 38, 42, 44) außerdem erste Tragemittel (36, 38) ohne Reibung des zweiten Trägers der Druckplatte (16) hinsichtlich der besagten Verbindungsplatte (12) umfassen, und daß die Mittel zum gemeinsamen Verschieben (12, 18, 20, 22, 24, 26, 28, 30A, 30B, 30C, 32A, 32B, 36, 38, 42) außerdem zweite Tragemittel (40, 42) ohne Reibung besagter Verbindungsplatte (12) im Hinblick auf den Rahmen (14) umfassen.

8. Anordnung zum Beleuchten nach Anspruch 5 und einem beliebigen der vorangegangenen Ansprüche, **dadurch gekennzeichnet, daß** die Mittel zum Zusammenbringen /Voneinanderentfernen mindestens eine Drehzapfenverbindung (48, 48A, 48B) zwischen dem ersten Träger des Druckbildes (10) und der Verbindungsplatte (12) umfassen, wodurch der erste Träger des Druckbildes (10) zwischen einer Ruheposition, bei der der erste Träger des Druckbildes (10) im wesentlichen parallel zum zweiten Träger des Druckbildes (16) angeordnet ist, und einer entfernten Position verschoben werden kann, bei der der erste Träger des Druckbildes (10) im wesentlichen nicht parallel zum zweiten Träger des Druckbildes (16) ist.

9. Anordnung zum Beleuchten nach einem beliebigen der vorangegangenen Ansprüche, **dadurch gekennzeichnet, daß** die Mittel zum Zusammenbringen / Voneinanderentfernen (48, 48A, 48B, 51, 52, 52A, 52B, 56, 54, 60A, 60B, 62, 64A, 64B) außerdem Mittel umfassen, die eine Stütze (52, 52A, 54, 62, 60A, 60B) ausbilden, die das Stützen des ersten Trägers des Druckbildes (10) zwischen einer Ruheposition, bei der der erste Träger des Druckbildes (10) im wesentlichen parallel zum zweiten Träger des Druckbildes (16) ist, wobei er um einen ersten Abstand (Dp) von diesem entfernt ist, und einer Beleuchtungsposition, bei der der erste Träger des Druckbildes (10) im wesentlichen parallel zum zweiten Träger des Druckbildes (16) ist, wobei er um einen zweiten Abstand (Di) von diesem entfernt ist, und wobei der besagte zweite Abstand (Di) deutlich kleiner oder gleich dem besagten ersten Abstand (Dp) ist, ermöglichen.

10. Anordnung zum Beleuchten nach dem vorangegangenen Anspruch, **dadurch gekennzeichnet, daß** die Mittel zum Zusammenbringen / Voneinanderentfernen (48, 48A, 48B, 51, 52, 52A, 52B, 56, 54, 60A, 60B, 62, 64A, 64B) mindestens eine Translationsführung (64A, 64B) umfassen, die es dem ersten Träger des Druckbildes (10) ermöglicht, im wesentlichen senkrecht zu seiner Ebene (X, Y) zwischen der Ruheposition und der Beleuchtungsposition verschoben zu werden.

11. Anordnung zum Beleuchten nach einem beliebigen der Ansprüche 9 bis 10, **dadurch gekennzeichnet, daß** die Mittel zur Stützung (52, 52A, 54, 62, 60A, 60B) außerdem Mittel umfassen, die einen Nocken (52, 52A) ausbilden, wobei jedes Mittel ein freies Ende (52A) aufweist, das geeignet ist, in eine Öffnung (54) einzudringen, die im ersten Träger des Druckbildes (1) ausgebildet ist, wenn der erste Träger des Druckbildes (10) ausgehend von einer entfernten Position, in der der erste Träger des Druckbildes (10) im wesentlichen nicht parallel zum zweiten Träger des Druckbildes (16) ist, in der Ruheposition ankommt.

12. Anordnung zum Beleuchten nach dem vorangegangenen Anspruch, **dadurch gekennzeichnet, daß** die Mittel zum Zusammenbringen / Voneinanderentfernen (48, 48A, 48B, 51, 52, 52A, 52B, 56, 54, 60A, 60B, 62, 64A, 64B) Mittel zur Blockierung (52B, 56, 56A) umfassen, die geeignet sind, den ersten Träger des Druckbildes (10) im Hinblick auf den zweiten Träger des Druckbildes (16) zu blockieren.

13. Anordnung zum Beleuchten nach Anspruch 5 und einem beliebigen der vorangegangenen Ansprüche, **dadurch gekennzeichnet, daß** die Haltemittel (66A, 66B, 68A, 68B) erste (66A, 66B) und zweite Mittel umfassen, die einen Zentrierbolzen (68A, 68B) ausbilden, wobei diese den zweiten Träger des Druckbildes (16) und die Verbindungsplatte (12) frei durchqueren, und welche jeweils ein freies Ende (68B) aufweisen, das geeignet ist, in eine Öffnung (70) einzudringen, die der Erkennungsmarkierung entspricht, die in der gedruckten Schaltungsplatte (46) ausgebildet ist.

14. Vorrichtung zum Beleuchten einer zweiseitig gedruckten Schaltungsplatte (46) mittels eines ersten (10) und eines zweiten (16) Druckbildes, wobei besagte erste und zweite Druckbilder (10, 16) jeweils mit einer Erkennungsmarkierung versehen sind, die umfaßt:
- Mittel zum Erfassen (21), um Positionierungsfehler zwischen besagter gedruckter Schaltungsplatte (46) und dem ersten (10) und dem zweiten (16) Träger des Druckbildes festzustellen, wobei die festgestellten Positionierungsfehler zwischen wenigstens dem ersten Träger des Druckbildes (10) und der gedruckten Schaltungsplatte (46) die Information zum gemeinsamen Verschieben darstellen, und die festgestellten Positionierungsfehler zwischen dem zweiten Träger (16) des Druckbildes und dem ersten Träger des Druckbildes (10) oder der gedruckten Schaltungsplatte (46) die Information zum getrennten Verschieben darstellen, und
- Mittel (13, 15) zur Erzeugung und Lenkung eines Lichtbündels (L) in Richtung eines jeden der ersten und zweiten Träger des Druckbildes (10, 16),
wobei diese Vorrichtung **dadurch gekennzeichnet ist, daß** sie mindestens eine Anordnung zum Beleuchten (11A, 11B) nach einem beliebigen der vorangegangenen Ansprüche umfaßt.

15. Vorrichtung nach dem vorangegangenen Anspruch, **dadurch gekennzeichnet, daß** sich die besagten Mittel zum Erfassen auf der Anordnung zum Beleuchten befinden.

16. Vorrichtung nach Anspruch 14 oder 15, **dadurch gekennzeichnet, daß** diese zwei Anordnungen zum Beleuchten (11A, 11B) umfaßt, sowie Mittel zum Verschieben (17), die das Verschieben der zwei Anordnungen zum Beleuchten (11A, 11B) im Verhältnis zueinander zwischen alternativ einer Belade-/Entladeposition der gedruckten Schaltungsplatte und einer Beleuchtungsposition gewährleisten.

17. Vorrichtung nach einem beliebigen der Ansprüche 14 bis 16, **dadurch gekennzeichnet, daß** die besagten Mittel zum Erfassen optische Mittel zum Erfassen (21) umfassen.

18. Vorrichtung nach einem beliebigen der Ansprüche 14 bis 17, **dadurch gekennzeichnet, daß** die besagten Mittel zur Erzeugung und Lenkung eines Lichtbündels (L) eine Lichtquelle (13) sowie optische Mittel (15) umfassen, um das Lichtbündel, das durch besagte Lichtquelle (13) ausgesendet wird, in Richtung eines jeden der besagten ersten und zweiten Träger des Druckbildes (10, 16) zu lenken.

19. Vorrichtung nach einem beliebigen der Ansprüche 14 bis 17, **dadurch gekennzeichnet, daß** besagte Mittel zur Erzeugung und Lenkung eines Lichtbündels (L) zwei Lichtquellen umfassen, die jeweils im Hinblick auf die ersten und zweiten Träger des Druckbildes (10, 16) angeordnet sind.
